# EUROPÄISCHE PATENTANMELDUNG

(11) **EP 4 137 830 A1**
(43) Veröffentlichungstag der Anmeldung: **22.02.2023**
(21) Anmeldenummer: 21192302.4
(22) Anmeldetag: 20.08.2021
(51) Int. Cl.: G01R 31/3828, G01R 31/388, G01R 31/392, H02J 7/00

(54) **VERFAHREN ZUM BESTIMMEN DER KAPAZITÄT EINES AKKUMULATORS**

(71) Anmelder: Hilti Aktiengesellschaft, 9494 Schaan (LI)
(72) Erfinder: Braun, Philipp, 87600 Kaufbeuren (DE); Mayer, Stefan, 86857 Hurlach (DE); Frenzel, Mathias, 86944 Unterdießen (DE); Martiny, Nora, 82211 Herrsching-Breitbrunn (DE)
(74) Vertreter: Hilti Aktiengesellschaft Corporate Intellectual Property

(57) **Zusammenfassung**

Verfahren zum Steuern und Regeln eines Akkumulators zur Versorgung einer Werkzeugmaschine mit elektrischer Energie, wobei der Akkumulator wenigstens eine Energiespeicherzelle, wenigstens eine Spannungsmesseinrichtung sowie eine Akku-Steuerungseinrichtung mit wenigstens einer Akku-Speichereinrichtung enthält.

Das Verfahren enthält die Verfahrensschritte:
- Erfassen einer ersten Leerlaufspannung des Akkumulators;
- Ermitteln eines ersten Ladungswerts in Abhängigkeit eines ersten erfassten Spannungswerts des Akkumulators;
- Ermitteln einer zugefügten Ladungsmenge während eines Ladevorgangs nach einer ersten Zeitdauer;
- Ermitteln eines zweiten Ladungswerts in Abhängigkeit eines zweiten erfassten Spannungswert des Akkumulators; und
- Bestimmen einer Restkapazität des Akkumulators aus dem Quotienten aus dem Quotienten der Summe der zugefügten Ladungsmenge und der Differenz des ersten und zweiten Ladezustands.

Akkumulator und Ladegerät zum Durchführen des Verfahrens.

## Beschreibung

Die vorliegende Erfindung betrifft ein Verfahren zum Steuern und Regeln eines Akkumulators zur Versorgung einer Werkzeugmaschine mit elektrischer Energie, wobei der Akkumulator wenigstens eine Energiespeicherzelle, wenigstens eine Spannungsmesseinrichtung sowie eine Akku-Steuerungseinrichtung mit wenigstens einer Akku-Speichereinrichtung enthält.

Des Weiteren betrifft die vorliegende Erfindung einen Akkumulator zum Durchführen des Verfahrens.

Darüber hinaus betrifft die vorliegende Erfindung ein Ladegerät zum Durchführen des Verfahrens.

Akkumulatoren werden oftmals zur Versorgung unterschiedlicher Vorrichtungen bzw. Maschinen mit elektrischer Energie verwendet. Die Verwendung von Akkumulatoren zur Versorgung von Werkzeugmaschinen, wie z.B. Bohrmaschinen, Bohrhämmer, Sägen, Schleifgeräte, Schrauber oder dergleichen, ist ebenfalls weitestgehend bekannt. Üblicherweise weisen Akkumulatoren eine Vielzahl an Energiespeicherzellen (auch Zellen oder Akku-Zellen genannt) zum Speichern bzw. Bereitstellen der elektrischen Energie auf. Die Technologie der Energiespeicherzellen kann dabei z.B. auf Li-Ion, Li-Polymer, Li-Metal, Ni-Cd, Ni-MH oder dergleichen basieren.

Die Kapazität bzw. die tatsächliche Leistungsfähigkeit der Energiespeicherzellen können sich über die Lebensdauer des Akkumulators durch verschiedene Alterungsmechanismen ändern bzw. verringern. Typischerweise verliert ein Akkumulator im Laufe seines Lebenszyklus an Kapazität und Leistungsfähigkeit, dieser Verlust hat einen direkten Einfluss auf den sogenannten "Gesundheitszustand" des Akkumulators. Der akute Gesundheitszustand eines Akkumulators wird oft auch als "State of Health" (SOH) bezeichnet.

Das korrekte bzw. genaue Bestimmen der tatsächlichen Kapazität bzw. des SOH eines Akkumulators ist notwendig, um den genauen Verwendungszeitraum bzw. die verbleibende Einsatzmöglichkeit eines Akkumulators als Energieversorgung ermitteln zu können. Ungenaue Angaben bzgl. der Kapazität bzw. Leistungsfähigkeit eines Akkumulators können dazu führen, dass ein Anwender von einer viel höheren (Rest-)Kapazität bzw. Leistungsfähigkeit eines Akkumulators ausgeht als wirklich zur Verfügung steht. Durch das Verwenden von Akkumulatoren mit einer unerwarteten zu geringen (Rest-)Kapazität bzw. Leistungsfähigkeit kann der Einsatz beispielsweise einer akkubetriebenen Werkzeugmaschine diskontinuierlich und deren Verwendung entsprechend ineffizient werden lassen.

Ebenso ist das korrekte bzw. genaue Bestimmen der tatsächlichen Kapazität bzw. des SOH eines Akkumulators erforderlich, um für ein schnelles und effektives Laden des Akkumulators die notwendige Lademenge an elektrischer Energie sowie die tatsächliche Ladezeit bestimmen zu können, wenn der Akkumulator durch ein Ladegerät geladen wird.

Es ist somit Aufgabe der vorliegenden Erfindung das vorstehend erwähnte Problem zu lösen und Verfahren zum Steuern und Regeln eines Akkumulators bereitzustellen, welches ein möglichst genaues Bestimmen der (Rest-)Kapazität bzw. Leistungsfähigkeit eines Akkumulator gewährleisten kann. Darüber hinaus ist es auch Aufgabe einen Akkumulator sowie ein Ladegerät zum Durchführen des Verfahrens bereitzustellen, wodurch ein möglichst genaues Bestimmen der Kapazität bzw. Leistungsfähigkeit eines Akkumulator gewährleistet werden kann.

Die Aufgabe wird gelöst durch den Gegenstand in Anspruch 1, 4 und 5. Vorteilhafte Ausführungsformen sind in den entsprechenden Unteransprüchen aufgeführt.

Die Aufgabe wird dabei gelöst durch ein Verfahren zum Steuern und Regeln eines Akkumulators zur Versorgung einer Werkzeugmaschine mit elektrischer Energie, wobei der Akkumulator wenigstens eine Energiespeicherzelle, wenigstens eine Spannungsmesseinrichtung sowie eine Akku-Steuerungseinrichtung mit wenigstens einer Akku-Speichereinrichtung enthält.

Erfindungsgemäß enthält das Verfahren die Verfahrensschritte:
- Einstellen des Akkumulators von einem ersten Ladezustand in einen zweiten Ladezustand;
- Ermitteln eines ersten Ladungswerts in Abhängigkeit eines ersten erfassten Spannungswerts des Akkumulators;
- Ermitteln einer zugefügten Ladungsmenge während eines Ladevorgangs nach einer ersten Zeitdauer;
- Ermitteln eines zweiten Ladungswerts in Abhängigkeit eines zweiten erfassten Spannungswert des Akkumulators; und
- Bestimmen einer Restkapazität des Akkumulators aus dem Quotienten der Summe der zugefügten Ladungsmenge und der Differenz des ersten und zweiten Ladungswertes.

Bei dem Verfahrensschritt des Einstellens des Akkumulators von einem ersten Ladezustand in einen zweiten Ladezustand kann es sich entweder um einen Ladevorgang, bei dem elektrische Energie von einem Ladegerät zu dem Akkumulator gelangt, oder um einen Entladevorgang, bei dem elektrische Energie von dem Akkumulator zu einer Werkzeugmaschine gelangt, handeln.

Gemäß einer vorteilhaften Ausgestaltung der vorliegenden Erfindung kann es möglich sein, dass das Verfahren die folgenden Verfahrensschritte enthält
- Erfassen eines dritten Spannungswertes des Akkumulators in Abhängigkeit eines dritten Ladungswertes, wobei der dritte Ladungswert einem im Wesentlichen vollständig geladenen Akkumulator entspricht;
- Ermitteln wenigstens eines vierten Spannungswertes des Akkumulators in Abhängigkeit wenigstens eines vierten Ladungswertes, wobei der wenigstens vierte Ladungswert einem prozentualen Anteil des dritten Ladungswertes entspricht; und
- Speichern des wenigstens vierten Spannungswertes in der Akku-Speichereinrichtung anstelle wenigstens eines ersten oder zweiten Spannungswertes für den Akkumulator.

Entsprechend einer weiteren vorteilhaften Ausgestaltung der vorliegenden Erfindung kann es möglich sein, dass das Verfahren die folgenden Verfahrensschritte enthält
- Erfassen eines dritten Spannungswertes des Akkumulators in Abhängigkeit eines dritten Ladungswertes, wobei der dritte Ladungswert einem im Wesentlichen vollständig geladenen Akkumulator entspricht;
- Ermitteln wenigstens eines vierten Ladungswertes des Akkumulators in Abhängigkeit wenigstens eines vierten Spannungswertes, wobei der wenigstens vierte Spannungswert einem prozentualen Anteil des dritten Spannungswertes entspricht; und
- Speichern des wenigstens vierten Ladungswertes in der Akku-Speichereinrichtung anstelle wenigstens eines ersten oder zweiten Ladungswertes für den Akkumulator.

Die spezifische Spannung Akkumulators, d.h. die maximale, nominelle oder minimale Spannung, ergibt sich aus der jeweiligen Akku-Zellentechnologie sowie aus der Anzahl an Akku-Zellen, die im Inneren des Akkumulators in Reihe geschaltet sind.

Dadurch, dass die Impedanz bzw. der Innenwiderstand des Akkumulators in einem direkten Zusammenhang mit der Kapazität und Leistungsfähigkeit des Akkumulators steht, kann durch den ermittelten Impedanz- bzw. Innenwiderstandswert die tatsächliche Kapazität und Leistungsfähigkeit des Akkumulators bestimmt werden. Je höher die Impedanz bzw. der Innenwiderstand des Akkumulators desto niedriger ist die Kapazität und Leistungsfähigkeit des Akkumulators. Die tatsächliche Kapazität und Leistungsfähigkeit des Akkumulators kann auch als der Gesundheitszustand (SoH) des Akkumulators bezeichnet werden.

Die Kapazität wird typischerweise in Ampere-Stunden (Ah) angegeben bzw. gemessen und bezeichnet die elektrische Ladung, die der Akkumulator enthalten kann. Sie berechnet sich aus der Kapazität einer einzelnen Akku-Zelle und aus der Anzahl an Akku-Zellen, die im Akkumulator in Parallel geschaltet (bzw. parallelgeschaltet) sind. Bei einer gegebenen Akkuspannung bedeutet dabei eine höhere Kapazität, dass der Akkumulator mehr Energie speichern kann.

Zur Angabe der Leistungsfähigkeit eines Akkumulators wird beispielsweise der maximale Strom angegeben, den ein Akkumulator liefern kann. Da die Akku-Zellen sich bei hohen Strömen erwärmen und nur in einem bestimmten Temperaturbereich betrieben werden dürfen, kann die Leistungsfähigkeit des Akkumulators auch durch einen Strom, den der Akkumulator für eine bestimmte Zeit oder bis zur kompletten Entladung liefern kann, beschrieben werden. Die Leistungsfähigkeit ist sehr stark abhängige von der Impedanz (Wechselstromwiderstand) des Akkumulators. Die Impedanz kann auch als Innenwiderstand der Akku-Zellen bzw. des Akkumulators.

Akkumulatoren für die Versorgung einer Werkzeugmaschine enthalten typischerweise Litiumlonen-Zellen (Li-Ion), die mit gewöhnlichen Ladegeräten in der Regel in einem sogenannten CCCV-Verfahren (Constant Current: konstanter Stromstärke; Constant Voltage: konstante Spannung) mit elektrischer Energie aufgeladen werden. Dabei generiert eine Ladeelektronik des Ladegeräts einen konstanten Ladestrom durch den Akkumulator (Constant Current - CC), so dass die Akkuspannung steigt. Sobald eine maximale Akkuspannung erreicht ist, wird diese von der Ladeelektronik konstant gehalten (Constant Voltage - CV) und der Ladestrom wird entsprechend reduziert. Ist ein vordefinierter Minimalwert des Ladestroms erreicht, beendet die Ladeelektronik den Ladevorgang und die Akku-Zellen sind vollgeladen. Der Übergang von der CC-Phase zu der CV-Phase erfolgt typischerweise bei einem Ladezustand (d.h. Kapazität) von ungefähr 80%.

Die Akkuspannung des Akkumulators ist in der Regel ein Vielfaches der Spannung einer einzelnen Akku-Zelle und ergibt sich aus der parallelen oder seriellen Verschaltung der Akku-Zellen. Bei Li-Ion-Akku-Zellen mit einer Zellspannung von 3,6 V ergeben sich somit beispielhafte Akkuspannungen von 3,6V, 7,2V, 10,8V, 14,4V, 18V, 36V etc. Bevorzugt ist die Akku-Zelle als zumindest im Wesentlichen zylinderförmige Rundzelle ausgebildet, wobei die Zellpole an Enden der Zylinderform angeordnet sind. Die elektrische Schnittstelle umfasst insbesondere zumindest zwei elektrische Kontaktelemente, die zur Übertragung von Energie ausgebildet sind. Alternativ kann die elektrische Schnittstelle aber auch ein sekundäres Ladespulenelement zur induktiven Ladung aufweisen.

In einer besonderen Ausgestaltung der Erfindung wird der Aufladevorgang mit dem CCCV-Verfahren durchgeführt, wobei zur Bestimmung der Restkapazität der erste Ladewert vor der CC-Phase und die weiteren Ladewerte während der CC-Phase und der CV-Phase ermittelt werden. Somit wird vor der CC-Phase die Leerlaufspannung gemessen und im Anschluss ein so genanntes "Coulumb Counting" durchgeführt, das zur Bestimmung der Ladung im Akkumulator die Anzahl der Elektronen erfasst.

Die Bestimmung der restlichen Leistungsfähigkeit des Akkumulators erfolgt vorzugsweise während der CC-Phase, indem der Ladestrom nach Erreichen der vordefinierten Akkuspannung für eine bestimmte Zeitdauer von einem ersten Wert auf einen zweiten Wert reduziert wird. Zudem kann zur Bestimmung der restlichen Leistungsfähigkeit des Akkumulators jeweils eine Wartezeit nach Veränderung des Ladestroms verstreichen, bis die Akkuspannung gemessen wird. Weiterhin ist vorgesehen, dass die Bestimmung der restlichen Leistungsfähigkeit in regelmäßigen Zeitabständen während des Aufladevorgangs, insbesondere während der CC-Phase, wiederholt wird.

Die Erhöhung der Impedanz im Laufe der Zeit ist ein Effekt der Alterung der Akku-Zellen. Die Impedanz der stromführenden Elemente (Kontakte, Leiterbahnen, Kabel, usw.) im Akkumulator oder im Ladegerät verändert sich dagegen nur vernachlässigbar. Es ist also besonders vorteilhaft, die Spannungsmessungen direkt im Akkumulator zu realisieren, um die Impedanzen der stromführenden Elemente zu ignorieren. Es können entweder die Spannung in den einzelnen Akku-Zellen oder die Spannung im gesamten Akkumulator ermittelt werden. Diese Impedanz-Messung kann entweder einmal oder mehrmals während des Ladevorgangs stattfinden. Mehrere Messungen erlauben eine Plausibilisierung und damit eine Vermeidung von Messfehlern, aber auch eine präzisere und detailliertere Abschätzung.

Die Restkapazität, die restliche Leistungsfähigkeit und/oder der Gesundheitszustand des Akkumulators können mit besonderem Vorteil auf einer externen Anzeigeeinheit ausgegeben werden. Dabei kann als Anzeigeeinheit sowohl ein Display (LCD, OLED, ePaper oder dergleichen) als auch eine LED-Anzeige des Akkumulators, des Ladegeräts oder alternativ bzw. ergänzend ein Smartphone, Tablet, PC oder dergleichen dienen. Die Kommunikation zwischen dem Akkumulator und den genannten Anzeigeeinheiten erfolgt über eine entsprechende Kommunikationsschnittstelle. Dabei kann ein proprietärer BUS verwendet werden, wie eine Übertragung per Standard- Protokolle per Kabel oder Funk.

Weitere Vorteile ergeben sich aus der folgenden Figurenbeschreibung. In den Figuren sind verschiedene Ausführungsbeispiele der vorliegenden Erfindung dargestellt. Die Figuren, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

In den Figuren sind gleiche und gleichartige Komponenten mit gleichen Bezugszeichen beziffert. Es zeigen:

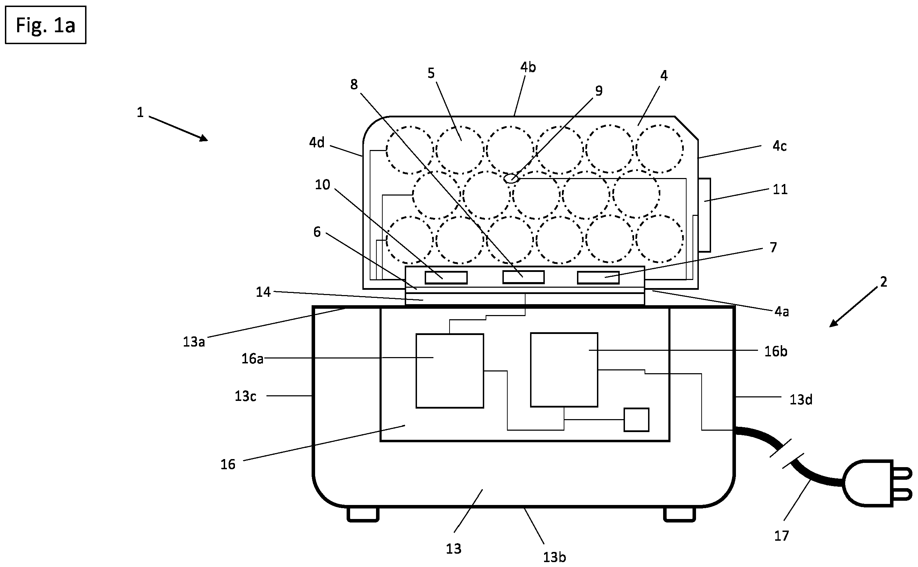

- Figur 1a: eine Schnittansicht durch einen Akkumulator verbunden mit einem Ladegerät;
- Figur 1: b eine Schnittansicht durch den Akkumulator verbunden mit einer Werkzeugmaschine;
- Figur 2: eine grafische Darstellung eines CCCV-Ladevorgangs; und
- Figur 3: ein grafische Darstellung zur Veranschaulichung des Bestimmen eines Impedanzwertes des Akkumulators.

### Ausführunasbeispiele:

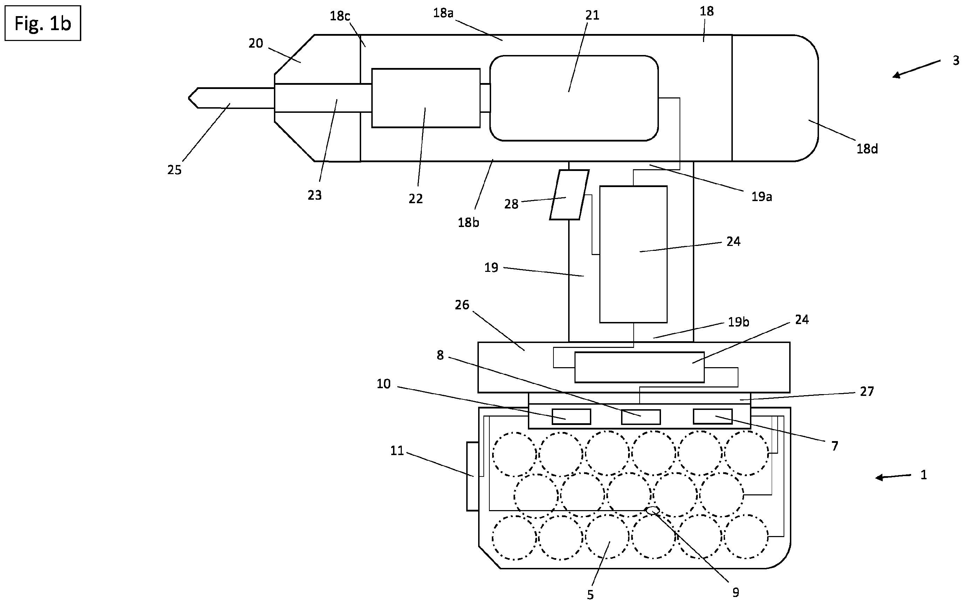

Figur 1 zeigt einen Akkumulator 1 wiederlösbar verbunden mit einem Ladegerät 2.

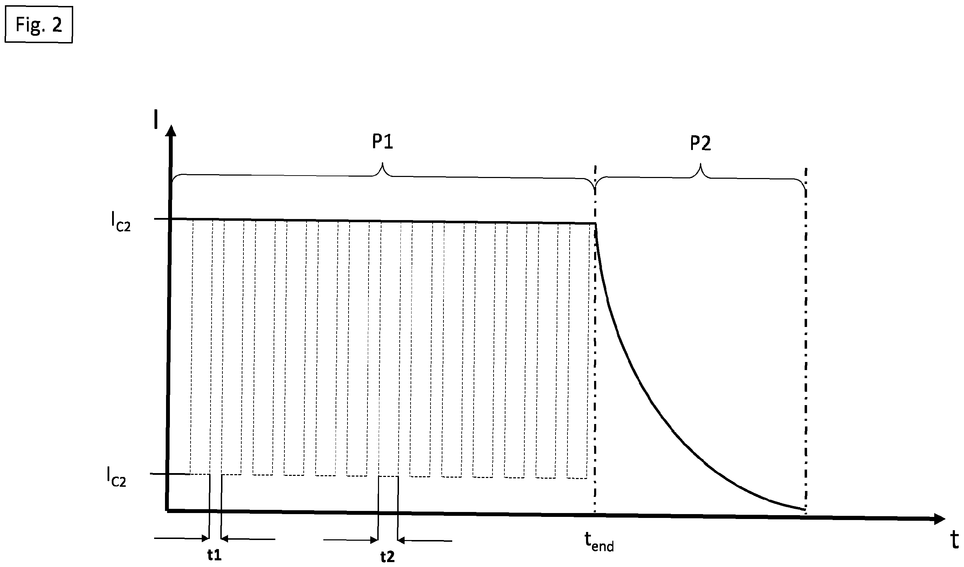

Der Akkumulator 1 kann als Energieversorgung für eine Werkzeugmaschine 3 verwendet werden. Die Werkzeugmaschine 3 ist in Form eines Akku-Schraubers in Figur 2 dargestellt.

Der Akkumulator 1 enthält im Wesentlichen ein Akku-Gehäuse 4, eine Anzahl an Energiespeicherzellen 5, eine Akku-Schnittstelle 6, eine Strommesseinrichtung 7, eine Spannungsmesseinrichtung 8, einen Temperatursensor 9, eine Akku-Speichereinrichtung 10, eine Anzeige- und Eingabeeinrichtung 11 sowie eine Akku-Steuerungseinrichtung 12.

Das Akku-Gehäuse 4 enthält eine Oberseite 4a, eine Unterseite 4b, eine linke Seitenwand, eine rechte Seitenwand, eine Vorderseite 4c und eine Rückseite. In Figur 1a ist lediglich die Oberseite 4a, Unterseite 4b, die Vorderseite 4c und die Rückseite 4d gezeigt.

Die Akku-Schnittstelle 6 ist an der Oberseite 4a des Akku-Gehäuses 4 positioniert und dient zum wiederlösbaren Verbinden des Akkumulators 3 mit dem Ladegerät 2 oder einer Werkzeugmaschine 3. Die Akku-Schnittstelle 6 enthält hierzu eine mechanische Ankopplungseinrichtung, eine elektrische Verbindungseinrichtung sowie einen Kommunikationsanschluss. Weder die mechanische Ankopplungseinrichtung, die elektrische Verbindungseinrichtung noch der Kommunikationsanschluss der Akku-Schnittstelle 6 sind in den Figuren gezeigt.

In den Figuren ist die mechanische Ankopplungseinrichtung, die elektrische Verbindungseinrichtung und der Kommunikationsanschluss der Akku-Schnittstelle 6 nicht gezeigt.

Durch die mechanische Ankopplungseinrichtung kann der Akkumulator 1 form- und kraftschlüssig entweder mit dem Ladegerät 2 oder mit einer Werkzeugmaschine 3 verbunden werden. Mit Hilfe der elektrischen Verbindungseinrichtung kann elektrische Energie von dem Ladegerät 2 zu dem Akkumulator 1 gelangen, wenn der Akkumulator 1 mit dem Ladegerät 2 verbunden ist. Ebenso kann elektrische Energie von dem Akkumulator 1 zu einer Werkzeugmaschine 3 gelangen, wenn de Akkumulator 1 mit der Werkzeugmaschine 3 verbunden ist. Der Kommunikationsanschluss dient dazu, dass Informationen und Daten in Form von Signale zwischen dem Akkumulator 1 und dem Ladegerät 2 bzw. zwischen dem Akkumulator 1 und der Werkzeugmaschine 3 ausgetauscht werden können. Zu den Informationen und Daten können unter anderem Lade- oder Entladeparameter, Temperaturwerte, Ladezustand (State of Charge - SOC), der Gesundheitszustand (State of Health - SOH), (Rest-)Kapazität, Spannung, Stromstärke oder dergleichen gehören.

Die Akku-Steuerungseinrichtung 12 ist im Wesentlichen in der Nähe der Oberseite des Akku-Gehäuses 4 positioniert und dient zum Steuern sowie Regeln der unterschiedlichen Funktionen des Akkumulators 1.

Die Energiespeicherzellen 5 sind im Inneren des Akku-Gehäuses 4 in drei Reihen positioniert, sodass zwischen der zweiten und dritten Reihe der Energiespeicherzellen 5 der Temperatursensor 9 positioniert ist. Der Temperatursensor 9 dient zum Erfassen der Temperatur im Inneren des Akkumulator 1 an einer der zentral positionierten Energiespeicherzellen 5. Der Temperatursensor 9 ist über eine Leitung mit der Akku-Steuerungseinrichtung 12 verbunden. Da die Energiespeicherzellen 5 im Inneren bzw. in der Mitte des Akkumulators 1 während des Lade- oder Entladevorgangs für gewöhnlich die höchsten Temperaturen ausweisen, kann ein Temperatursensor 9, der an dieser zentral positionierten Energiespeicherzelle 5 die Temperatur erfasst, die höchste Temperatur und damit am schnellsten eine kritisch hohe Temperatur für den Akkumulator 1 feststellen.

Des Weiteren ist innerhalb der Akku-Steuerungseinrichtung 12 die Strommesseinrichtung 7, die Spannungsmesseinrichtung 8 und die Akku-Speichereinrichtung 10 enthalten.

Die Strommesseinrichtung 7 dient zum Erfassen bzw. Messen der Stromstärke an den einzelnen Energiespeicherzellen 5. Wie in Figur 1a angedeutet ist die Strommesseinrichtung 7 daher mit jeder einzelnen Energiespeicherzelle 5 verbunden. Durch das Erfassen bzw. Messen der Stromstärke an der einzelnen Energiespeicherzelle 5 kann die Stromstärke für den gesamten Akkumulator 1 ermittelt werden.

Die Spannungsmesseinrichtung 8 dient zum Erfassen bzw. Messen der Spannung an den einzelnen Energiespeicherzellen 5. Wie in Figur 1a angedeutet ist die Spannungsmesseinrichtung 8 daher mit jeder einzelnen Energiespeicherzelle 5 verbunden. Durch das Erfassen bzw. Messen der Spannung an der einzelnen Energiespeicherzelle 5 kann die Spannung für den gesamten Akkumulator 1 ermittelt werden.

Die Speichereinrichtung 10 dient zum Speichern und Bereitstellen unterschiedlichster Informationen und Daten, wie z.B. Look-Up-Tabellen für die verschiedenen Lade- oder EntladeParameter des Akkumulators 1. Zu diesen Parametern gehören unter anderen Temperaturverläufe bzw. Schwellwerte für Spannungen oder Stromstärken.

Die Anzeige- und Eingabeeinrichtung 11, welche auch als Human-Machine-Interface (HMI) bezeichnet werden kann, ist an der Vorderseite des Akku-Gehäuses 4 positioniert. Wie in Figur 1a angedeutet ist die Anzeige- und Eingabeeinrichtung 11 mit der Akku-Steuerungseinrichtung 12 verbunden, sodass unterschiedliche Daten und Informationen auf einem Anzeigeanteil der Anzeige- und Eingabeeinrichtung 11 ersichtlich sind. Insbesondere kann der Ladezustand bzw. Auf einem Eingabeanteil der Anzeige- und Eingabeeinrichtung 11 kann ein Anwender unterschiedliche Betriebszustände (oder auch Betriebsmodi oder Modi genannt) für den Akkumulator 1 ausgewählt und eingestellt werden. Zu den unterschiedlichen Betriebszuständen zählen beispielsweise bestimmte Lade- oder Entladezustände. Bei einem ersten auswählbaren Betriebszustand wird für den Akkumulator 1 ein CCCV-Ladeverfahren eingestellt. Bei einem zweiten auswählbaren Betriebszustand wird für den Akkumulator 1 ein Schnellladeverfahren eingestellt, bei dem mit relativ hohen Ladeströmen eine relativ kurze Ladezeit erreicht werden kann. Bei einem dritten auswählbaren Betriebszustand wird für den Akkumulator 1 ein langsames und schonendes Ladeverfahren eingestellt, bei dem mit relativ niedrigen Ladeströmen zwar eine relativ lange Ladezeit, aber auch ein für die Energiespeicherzellen 5 schonendes (d.h. wenig belastendes) Laden erreicht werden kann.

Das Ladegerät 2 enthält ein Ladegerät-Gehäuse 13, ein Ladegerät-Schnittstelle 14, eine Ladegerät-Speichereinrichtung 15 sowie eine Ladegerät-Steuerungseinrichtung 16.

Die Ladegerät-Steuerungseinrichtung 16 enthält eine Strommesseinrichtung 16a und eine Spannungsmesseinrichtung 16b.

Das Ladegerät-Gehäuse 13 enthält eine Oberseite 13a, eine Unterseite 13b, eine linke Seitenwand, eine rechte Seitenwand, eine Vorderseite 13c und eine Rückseite 13d. In Figur 1a ist lediglich die Oberseite 13a, Unterseite 13b, die Vorderseite 13c und die Rückseite 13d gezeigt.

Die Ladegerät-Schnittstelle 14 ist an der Oberseite 13a des Ladegerät-Gehäuses 13 positioniert und dient zum wiederlösbaren Verbinden des Ladegeräts 2 mit dem Akkumulator 1. Die Ladegerät-Schnittstelle 14 enthält hierzu eine mechanische Ankopplungseinrichtung, eine elektrische Verbindungseinrichtung sowie einen Kommunikationsanschluss. Weder die mechanische Ankopplungseinrichtung, die elektrische Verbindungseinrichtung noch der Kommunikationsanschluss der Ladegerät-Schnittstelle 14 sind in den Figuren gezeigt.

Die mechanische Ankopplungseinrichtung, die elektrische Verbindungseinrichtung und der Kommunikationsanschluss des Ladegeräts 2 sind zu der mechanischen Ankopplungseinrichtung, der elektrischen Verbindungseinrichtung und dem Kommunikationsanschluss des Akkumulators 1 korrespondierend ausgestaltet, sodass die Komponenten der Ladegerät-Schnittstelle 14 und der Akku-Schnittstelle 6 entsprechend miteinander verbunden werden können.

In den Figuren ist die mechanische Ankopplungseinrichtung, die elektrische Verbindungseinrichtung und der Kommunikationsanschluss der Ladegerät-Schnittstelle 14 nicht gezeigt.

Des Weiteren verfügt das Ladegerät 2 über ein Stromanschlusskabel 17, welches aus dem Ladegerät-Gehäuse 14 herausragt und mit der Ladegerät-Steuerungseinrichtung 16 verbunden ist. Das Stromanschlusskabel 17 dient zum wiederlösbaren Verbinden des Ladegeräts 2 mit einer Netzstromquelle (Steckdose).

Figur 2 zeigt den Akkumulator 1 wiederlösbar verbunden mit der Werkzeugmaschine 3. Wie bereits vorstehend beschriebenen Werkzeugmaschine 3 ist in Figur 2 als Akku-Schrauber ausgestaltet. Alternativ kann die Werkzeugmaschine 3 auch als Bohrhammer, Bohrmaschine, Säge, Schleifgerät oder dergleichen ausgestaltet sein. Die als Akku-Schrauber ausgestaltete Werkzeugmaschine 3 enthält im Wesentlichen ein Gehäuse 18, einen Handgriff 19 sowie eine Werkzeugaufnahme 20.

Das Gehäuse 18 der Werkzeugmaschine 2 enthält wiederum eine Oberseite 18a, eine Unterseite 18b, ein vorderes Ende 18c und ein hinteres Ende 18d. Im Inneren des Gehäuses 18 ist im Wesentlichen ein Antrieb 21, ein Getriebe 22, eine Abtriebswelle 23 und eine Steuervorrichtung 24 enthalten. Der Antrieb 21 ist als Elektromotor ausgestalte und dient zum Erzeugen eines Drehmoments. Wie in Figur 2 gezeigt ist der Antrieb 21, das Getriebe 22, die Abtriebswelle 23 und die Werkzeugaufnahme 20 so zueinander angeordnet, dass ein von dem Antrieb 21 erzeugtes Drehmoment über das Getriebe 22 und die Abtriebswelle 23 auf die Werkzeugaufnahme 20 übertragen werden kann.

An dem vorderen Ende 18c ist die Werkzeugaufnahme 20 positioniert, die zum Aufnehmen und Halten eines Werkzeugs 25 dient. Bei dem Werkzeug 25 handelt es sich um ein Schrauber-Bit. Der Handgriff 19 dient zum Halten und Führen der Werkzeugmaschine 3 durch einen (nicht gezeigten) Anwender. Der Handgriff 19 enthält dabei ein oberes Ende 19a und ein unteres Ende 19b. Der Handgriff 19 ist mit dem oberen Ende 19a an der Unterseite 19b des Gehäuses 19 der Werkzeugmaschine 2 befestigt. An dem unteren Ende 19b des Handgriffs 19 ist eine Fussvorrichtung 26 mit einer Werkzeugmaschinen-Schnittstelle 27 positioniert.

Des Weiteren weist der Handgriff 19 einen Aktivierungsschalter 28 auf, der mit der Steuereinrichtung 24 verbunden ist. Durch den Aktivierungsschalter 28 kann ein Anwender die Werkzeugmaschine 2 je nach Positionierung des Aktivierungsschalter 28 in einen Aktivierungs- oder Deaktivierungszustand versetzen. In einem Aktivierungszustand erzeugt der Antrieb 21 ein Drehmoment.

Die Werkzeugmaschinen-Schnittstelle 27 dient zum wiederlösbaren Verbinden der Werkzeugmaschine 3 mit dem Akkumulator 1. Die Werkzeugmaschinen-Schnittstelle 27 enthält hierzu eine mechanische Ankopplungseinrichtung, eine elektrische Verbindungseinrichtung sowie einen Kommunikationsanschluss.

Die mechanische Ankopplungseinrichtung, die elektrische Verbindungseinrichtung und der Kommunikationsanschluss der Werkzeugmaschine 3 sind zu der mechanischen Ankopplungseinrichtung, der elektrischen Verbindungseinrichtung und dem Kommunikationsanschluss des Akkumulators 1 korrespondierend ausgestaltet, sodass die Komponenten der Werkzeugmaschine 3 und der Akku-Schnittstelle 6 entsprechend miteinander verbunden werden können.

In den Figuren ist die mechanische Ankopplungseinrichtung, die elektrische Verbindungseinrichtung und der Kommunikationsanschluss der Werkzeugmaschine 3 nicht gezeigt.

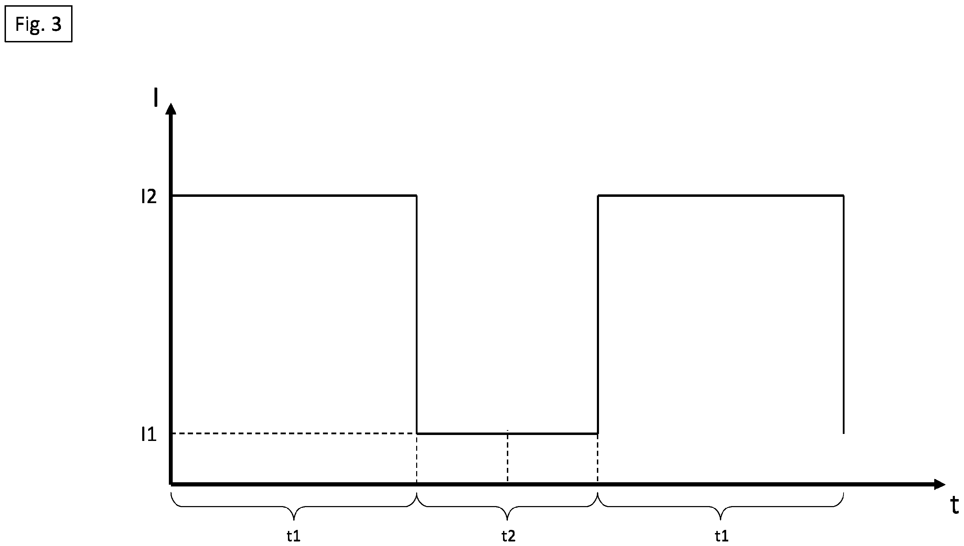

Figur 3 zeigt grafische Darstellung eines CCCV-Ladevorgangs, wobei das Ladegerät 2 einen konstanten Ladestrom (CC - constant current) I_{C2} in der Phase P1 bereitstellt bis eine maximale Akku-Spannung erreicht wurde. Ab einem Zeitpunkt t_{end} wird während einer zweiten Phase P2 der Wert des Ladestroms I_{C2} kontinuierlich reduziert, wobei die Akku-Spannung konstant (CV - constant voltage) bleibt.

Zur Durchführung des Verfahrens wird zunächst der Akkumulator 1 mit dem Ladegerät 2 so verbunden, dass die entsprechenden mechanischen Ankopplungseinrichtungen, die elektrischen Verbindungseinrichtungen und die Kommunikationsanschlüsse des Akkumulators 1 und des Ladegeräts 2 miteinander gekoppelt sind. Durch die Kopplung der Kommunikationsanschlüsse des Akkumulators 1 und des Ladegeräts 2 werden Daten und Informationen bezüglich der Ladespezifikation bzw. Ladeparameter, insbesondere Schwellwerte für eine maximalen Ladestrom oder eine maximale Ladespannung zwischen dem Akkumulator 1 und dem Ladegerät 2 ausgetauscht.

Bevor der Akkumulator 1 durch das Ladegerät 2 mit elektrischer Energie geladen wird, wird zunächst die Leerlaufspannung (auch open-circuit voltage oder OCV genannt) des Akkumulators 1 gemessen und erfasst. Der Wert der erfassten Leerlaufspannung wird in der Akku-Speichereinrichtung 10 gespeichert, wobei bei jedem Ladevorgang der Wert für die Leerlaufspannung in der Akku-Speichereinrichtung 10 hinterlegt wird. Nach einer gewissen Zeitdauer (d.h. beispielsweise 2 bis 8 Monate) werden die in der Akku-Speichereinrichtung 10 gespeicherten Werte für die Leerlaufspannung miteinander verglichen. Wenn der Wert der Leerlaufspannung einen vorbestimmten Schwellwert erreicht, wird an der Anzeige- und Eingabeeinrichtung 11 des Akkumulators 1 ein entsprechender (optischer) Hinweis auf das Erreichen des Leerlaufspannungsschwellwerts einem Anwender angezeigt. Alternativ kann durch das Erreichen des Leerlaufspannungsschwellwerts die weitere Verwendung des Akkumulators 1, d.h. das Abgeben und/oder das Aufnehmen von elektrischer Energie aus oder in den Akkumulator 1 durch die Akku-Steuerungseinrichtung 12, elektronisch blockiert und damit verhindert.

Durch das Verbinden der elektrischen Verbindungseinrichtungen des Akkumulators 1 und des Ladegeräts 2 wird als nächstes elektrische Energie von dem Ladegerät 2 zum Akkumulator 1 geleitet, wobei ein Wert für eine Ladestromstärke I_{C2} an dem Ladegerät 2 eingestellt ist. Das Einstellen des Wertes für die Ladestromstärke I_{C2} erfolgt dabei durch ein entsprechendes Signal von dem Akkumulator 1 über die Kommunikationsanschlüsse an das Ladegerät 2. Die Ladespannung U_{R1} bei einer Ladestromstärke I_{C2} wird mit Hilfe der Spannungsmesseinrichtung 8 des Akkumulators 1 erfasst. Alternativ kann die Ladespannung U_{R1} bei der eine Ladestromstärke I_{C2} wird mit Hilfe der Spannungsmesseinrichtung des Ladegeräts 2 erfasst werden. Der erfasste Wert für die Ladespannung U_{R1} wird in der Akku-Speichereinrichtung 10 gespeichert. Alternativ kann der erfasste Wert für die Ladespannung U_{R1} in der Ladegerät-Speichereinrichtung 15 gespeichert werden.

Zum Ermitteln eines Ladungswertes in Abhängigkeit oder entsprechend der Ladespannung U_{R1} sind in der Akku-Speichereinrichtung 10 Daten in Form von Tabellen (auch Look-Up-Tabellen genannt) und Grafen (bzw. grafische Verlaufskurven) hinterlegt, die für den spezifischen Akkumulator 1 das Verhältnis zwischen Akku-Spannung und Akku-Ladungswert beschreiben. Der Ladungswert kann dabei auch als Ladung oder Ladezustand bzw. State-of-Charge (SOC) bezeichnet werden.

Während des eigentlichen Ladevorgangs bzw. dem Hinzufügen von elektrischer Energie in die Energiespeicherzellen 5 des Akkumulators 1 wird in regelmäßigen Zeitabständen der Ist-Wert der Ladestromstärke I_{C2} gemessen und mit Hilfe der Akku-Steuerungseinrichtung 12 mit dem Soll-Wert überprüft und ggf. angepasst. Der zu dem Akkumulator 1 während des Ladevorgangs hinzugefügte Ladungswert wird anhand des Produktes aus dem Ist-Wert der Ladestromstärke I_{C2} und der Ladezeit (in Sekunden) in einem der Zeitabstände ermittelt. Durch das Laden des Akkumulators 1 bzw. das Hinzufügen von elektrischer Energie erhöht sich entsprechend die Spannung im Akkumulator 1 bzw. die Spannung in den Energiespeicherzellen 5.

Nach einer Zeitdauer, beispielsweise 20 bis 60 Sekunden, nach Beginn des Ladevorgangs wird ein weiterer Ladungswert in Abhängigkeit eines erhöhten Spannungswertes in den Energiespeicherzellen 5 ermittelt. Wie bereits vorstehend beschrieben wird der Ladungswert entsprechend des derzeitigen Spannungswertes anhand von in der Akku-Speichereinrichtung 10 gespeicherten Daten in Form von Tabellen (auch Look-Up-Tabellen genannt) und Grafen ermittelt. In regelmäßigen Zeitabständen wird der Ladungswert in Abhängigkeit eines aktuellen Spannungswertes erfasst und in der Akku-Speichereinrichtung 10 hinterlegt.

Zum Bestimmen der Kapazität des Akkumulators 1 wird der Quotient der Summe der zugefügten Ladungsmenge und der Differenz des ersten und zweiten Ladungswertes berechnet. Bei dem ersten Ladungswert kann es sich um den ersten ermittelten Ladungswert in Abhängigkeit eines ersten erfassten Spannungswerts handeln. Bei dem zweiten Ladungswert kann es sich um den vor Beendigung des Ladevorgangs letzten ermittelten Ladungswert in Abhängigkeit eines zuletzt erfassten Spannungswerts handeln. Die ermittelte Kapazität des Akkumulators 1 kann dabei auch als Restkapazität bezeichnet werden, da diese die verbleibende Menge an Ladung bzw. an elektrischer Energie beschreiben kann, die sich noch im Akkumulator 1 zu dem bestimmten Zeitpunkt befindet.

Durch einen Alterungsprozess (insbesondere durch die Erhöhung des Innenwiderstands bzw. Impedanz) des Akkumulators 1 und/oder durch ein Überschreiten einer gewissen Anzahl an Ladung- und Entladungszyklen entspricht die ursprüngliche Kapazität der Energiespeicherzellen 5 nicht mehr den ursprünglich hinterlegten Spannungswerten.

Um die reduzierte Kapazität an die tatsächlich erfassten Spannungswerte anzupassen und schließlich in der Akku-Speichereinrichtung 10, wird ein aktueller Spannungswert des Akkumulators 1 in Abhängigkeit eines aktuellen Ladungswertes erfasst. Hierbei entspricht dieser aktuelle Ladungswert einem im Wesentlichen vollständig geladenen Akkumulator 1. Anschließend wird ein weiterer (späterer) Ladungswert des Akkumulators 1 in Abhängigkeit wenigstens eines weiteren aktuellen Spannungswertes ermittelt. Dieser weitere Spannungswert entspricht einem prozentualen Anteil des zuvor erfassten Spannungswertes und wird als neuen Referenzwert für die Spannung entsprechend der Kapazität in der Akku-Speichereinrichtung 10 hinterlegt bzw. gespeichert.

Das Verfahren kann alternativ auch mit vorstehend beschriebenen Verfahrensschritten entsprechend die Spannungswerte an die tatsächlich erfassbaren Ladungswerte angepasst werden. Das vorstehende beschriebene Verfahren beschreibt einen Ladevorgang des Akkumulators 1 an dem Ladegerät 2. Das Verfahren kann jedoch auch für einen Entladevorgang des Akkumulators 1 als Energieversorgung an einer Werkzeugmaschine 3 verwendet werden. Das Verfahren bei einem Entladevorgang des Akkumulators 1 ist dem Ladevorgang des Akkumulators 1 nahezu identisch. Im Gegensatz zu dem Verfahren bei dem Ladevorgang des Akkumulators 1 gelangt bei dem Entladevorgang elektrische Energie von dem Akkumulator 1 zu der Werkzeugmaschine 3.

### Bezuaszeichenliste

- 1: Akkumulator
- 2: Ladegerät
- 3: Werkzeugmaschine
- 4: Akku-Gehäuse
- 4a: Oberseite des Akku-Gehäuses
- 4b: Unterseite des Akku-Gehäuses
- 4c: Vorderseite des Akku-Gehäuses
- 4d: Rückseite 4d des Akku-Gehäuses
- 5: Energiespeicherzelle
- 6: Akku-Schnittstelle
- 7: Strommesseinrichtung des Akkumulators
- 8: Spannungsmesseinrichtung des Akkumulators
- 9: Temperatursensor des Akkumulators
- 10: Akku-Speichereinrichtung
- 11: Anzeige- und Eingabeeinrichtung
- 12: Akku-Steuerungseinrichtung
- 13: Ladegerät-Gehäuse
- 13a: Oberseite des Ladegerät-Gehäuses
- 13b: Unterseite des Ladegerät-Gehäuses
- 13c: Vorderseite des Ladegerät-Gehäuses
- 13d: Rückseite des Ladegerät-Gehäuses
- 14: Ladegerät-Schnittstelle
- 15: Ladegerät-Speichereinrichtung
- 16: Ladegerät-Steuerungseinrichtung
- 116a: Strommesseinrichtung
- 16b: Spannungsmesseinrichtung
- 17: Stromanschlusskabel
- 18: Gehäuse der Werkzeugmaschine
- 18a: Oberseite des Werkzeugmaschinengehäuses
- 18b: Unterseite des Werkzeugmaschinengehäuses
- 18c: vorderes Ende des Werkzeugmaschinengehäuses
- 18d: hinteres Ende des Werkzeugmaschinengehäuses
- 19: Handgriff
- 20: Werkzeugaufnahme
- 21: Antrieb
- 22: Getriebe
- 23: Abtriebswelle
- 24: Steuervorrichtung
- 25: Werkzeug
- 26: Fussvorrichtung
- 27: Werkzeugmaschinen-Schnittstelle
- 28: Aktivierungsschalter

## Patentansprüche

1. Verfahren zum Steuern und Regeln eines Akkumulators (1) zur Versorgung einer Werkzeugmaschine (3) mit elektrischer Energie, wobei der Akkumulator (1) wenigstens eine Energiespeicherzelle (5), wenigstens eine Spannungsmesseinrichtung (8) sowie eine Akku-Steuerungseinrichtung (12) mit wenigstens einer Akku-Speichereinrichtung (10) enthält,
**gekennzeichnet durch** die Verfahrensschritte
- Einstellen des Akkumulators (1) von einem ersten Ladezustand in einen zweiten Ladezustand;
- Ermitteln eines ersten Ladungswerts in Abhängigkeit eines ersten erfassten Spannungswerts des Akkumulators (1);
- Ermitteln einer zugefügten Ladungsmenge während eines Ladevorgangs nach einer ersten Zeitdauer;
- Ermitteln eines zweiten Ladungswerts in Abhängigkeit eines zweiten erfassten Spannungswert des Akkumulators (1); und
- Bestimmen einer Restkapazität (C_{REST}) des Akkumulators (1) aus dem Quotienten der Summe der zugefügten Ladungsmenge und der Differenz des ersten und zweiten Ladungswertes.

2. Verfahren nach Anspruch 1,
**gekennzeichnet durch**
- Erfassen eines dritten Spannungswertes des Akkumulators (1) in Abhängigkeit eines dritten Ladungswertes, wobei der dritte Ladungswert einem im Wesentlichen vollständig geladenen Akkumulator (1) entspricht;
- Ermitteln wenigstens eines vierten Spannungswertes des Akkumulators (1) in Abhängigkeit wenigstens eines vierten Ladungswertes, wobei der wenigstens vierte Ladungswert einem prozentualen Anteil des dritten Ladungswertes entspricht; und
- Speichern des wenigstens vierten Spannungswertes in der Akku-Speichereinrichtung (10) anstelle wenigstens eines ersten oder zweiten Spannungswertes für den Akkumulator (1).

3. Verfahren nach Anspruch 1 oder 2,
**gekennzeichnet durch**
- Erfassen eines dritten Spannungswertes des Akkumulators (1) in Abhängigkeit eines dritten Ladungswertes, wobei der dritte Ladungswert einem im Wesentlichen vollständig geladenen Akkumulator (1) entspricht;
- Ermitteln wenigstens eines vierten Ladungswertes des Akkumulators (1) in Abhängigkeit wenigstens eines vierten Spannungswertes, wobei der wenigstens vierte Spannungswert einem prozentualen Anteil des dritten Spannungswertes entspricht; und
- Speichern des wenigstens vierten Ladungswertes in der Akku-Speichereinrichtung (10) anstelle wenigstens eines ersten oder zweiten Ladungswertes für den Akkumulator (1).

4. Akkumulator (1) zum Durchführen des Verfahrens nach Anspruch 1 oder 2,
**dadurch gekennzeichnet, dass** der Akkumulator (1) wenigstens eine Energiespeicherzelle (5), wenigstens eine Spannungsmesseinrichtung (8) sowie eine Akku-Steuerungseinrichtung (12) mit wenigstens einer Akku-Speichereinrichtung (10) enthält.

5. Ladegerät (2) zum Durchführen des Verfahrens nach Anspruch 1 oder 2,
**dadurch gekennzeichnet, dass** das Ladegerät (2) eine Ladegerät-Steuereinrichtung (16) mit wenigstens einer Ladegerät-Speichereinrichtung (15) enthält.
